# EUROPEAN PATENT SPECIFICATION

(11) **EP 3 297 770 B1**
(45) Date of publication and mention of the grant of the patent: **30.08.2023**
(21) Application number: 16797424.5
(22) Date of filing: 20.05.2016
(51) Int. Cl.: B05D 5/06, B05D 7/24, C09K 11/00, C09D 5/22, H01L 33/04, H01L 33/44, G02F 1/017, G02F 1/1335

(54) **INSULATOR-COATED QUANTUM DOTS FOR USE IN LED LIGHTING AND DISPLAY DEVICES**
ISOLATORBESCHICHTETE QUANTENPUNKTE ZUR VERWENDUNG IN DER LED-BELEUCHTUNG UND ANZEIGEVORRICHTUNGEN
POINTS QUANTIQUES REVÊTUS D'ISOLANT À UTILISER DANS DES DISPOSITIFS D'AFFICHAGE ET D'ÉCLAIRAGE À DEL

(30) Priority: 20.05.2015 US 201562164430 P
(43) Date of publication of application: 28.03.2018
(73) Proprietor: OSRAM Opto Semiconductors GmbH, 93055 Regensburg (DE)
(72) Inventor: ZHAO, Weiwen, Happy Valley, Oregon 97086 (US); MCLAUGHLIN, Nathan, Portland, Oregon 97223 (US); JANSEN, Michael, Palo Alto, California 94301 (US); KURTIN, Juanita, Hillsboro, Oregon 97124 (US)
(74) Representative: Epping - Hermann - Fischer
(86) International application number: PCT/US2016/033656
(87) International publication number: WO 2016/187599

(56) References cited:
- WO-A1-2009/052122
- WO-A1-2015/002842
- WO-A1-2015/109161
- WO-A2-2012/135744
- US-A1- 2003 127 659
- US-A1- 2004 266 148
- US-A1- 2010 177 496
- US-A1- 2012 250 351
- US-A1- 2015 011 029

## Description

### BACKGROUND

What is needed is a method for applying quantum dots to an LED lighting or display device.

WO 2012/1235744 A2, US 2004/266148 A1, and WO 2015/109161 A1 disclose methods, in which coated quantum dots are dispensed on a sheet, which is then installed in a LED lighting or display device.

### SUMMARY

Embodiments of the invention involve coating a plurality of quantum dots with one or more insulating layers. The coated quantum dots are then dispensed in a sheet that is installed in a light emitting diode (LED) lighting or electronic display device.

### BRIEF DESCRIPTION OF THE DRAWINGS

Fig. 1 is an image from a Transmission Electron Microscope (TEM) of a quantum dot coated with an insulator layer according to an embodiment of the invention.
Fig. 2 is a flow diagram according to embodiments of the invention.
Fig. 3A is an apparatus manufactured according to embodiments of the invention.
Fig. 3B is an apparatus manufactured according to embodiments of the invention.
Fig. 3C is an apparatus manufactured according to embodiments of the invention.
Fig. 4 provides an example of quantum dots with an insulator layer according to an embodiment of the invention.
Fig. 5 is an illustration of a semiconductor structure that has a nanocrystalline core and nanocrystalline shell pairing with one compositional transition layer, in accordance with an embodiment of the invention.
Fig. 6 illustrates a nano-particle in accordance with an embodiment of the invention.
Fig. 7 illustrates a coated quantum dot fabricated according to an embodiment of the invention.

### DETAILED DESCRIPTION

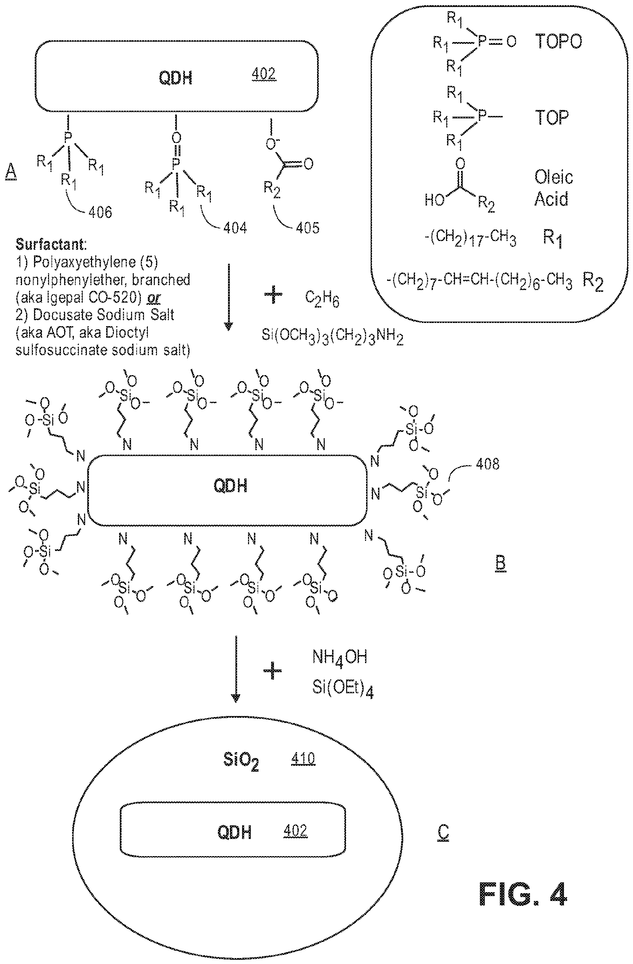

Quantum dots are materials which are beneficial in many applications, but which often cannot withstand thousands of hours of operation under the environmental and operating conditions of many products, for example, light emitting diode (LED) or solar devices. According to embodiments of the invention, quantum dots are made robust for certain applications by individually coating the surfaces of the quantum dots with an insulating layer of metal oxide (for example silica, titania, alumina, etc.). An example of quantum dots with an insulator layer is described below with reference to Fig. 4. However, this insulating layer may not be sufficient to protect the quantum dots in all operating or environmental conditions, due to the imperfect or porous coverage of the metal oxide. According to one embodiment, adding at least another layer of metal oxide or other insulating material makes the quantum dots more robust, and thermally stable, by further protecting the surfaces and filling in any imperfections or pores. According to another embodiment, quantum dots are dispensed in a sheet. In this embodiment, the quantum dots are coated with one or more insulating layers before being dispensed in the sheet to avoid or reduce the need for the sheet to be encapsulated with expensive oxygen and moisture barrier layers, which would increase the cost and manufacturing complexity greatly.

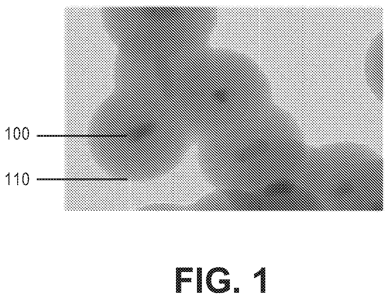

Additionally, in order to ensure that there is no self-quenching of photoluminescence or other interactions between or among quantum dots, in one embodiment, the first insulating layer serves as an adjustable spacer that allows the quantum dots to remain fully dispersed and spaced apart prior to adding a second insulating layer. By adding a metal oxide insulating layer by a reverse micelle or similar process, the individual quantum dots 100 are coated with enough material 110 to ensure adequate monodispersity, as seen in the Transmission Electron Microscope (TEM) image in Fig.1, and avoid self-quenching.

Finally, metal oxide coating of quantum dots prior to adding further insulating coating renders the quantum dots more thermally stable so they can sustain a much higher processing temperature than uncoated quantum dots.

### Example of Quantum Dots with an Insulator layer

As explained above, embodiments of the invention involve forming multiple insulator coatings on quantum dots, including optional base or acid treatments in between coatings. The following is an example of quantum dots that may be treated and/ or coated with insulator layers according to the above-described methods. Although the following examples may occasionally refer to a first or single insulator coating, the description may apply to any of the multiple insulator coatings. Additionally, the above-described methods may apply to any type of quantum dots, and are not limited to the below-described coated quantum dots.

In a general embodiment, a semiconductor structure includes a nanocrystalline core composed of a first semiconductor material. The semiconductor structure also includes a nanocrystalline shell composed of a second, different, semiconductor material at least partially surrounding the nanocrystalline core. Additional nanocrystalline shells may also be formed that surround the core/shell pairing. An insulator layer encapsulates, e.g., coats, the nanocrystalline shell(s) and nanocrystalline core. Thus, coated semiconductor structures include coated structures such as the quantum dots described above. For example, in an embodiment, the nanocrystalline core is anisotropic, e.g., having an aspect ratio between, but not including, 1.0 and 2.0. In another example, in an embodiment, the nanocrystalline core is anisotropic and is asymmetrically oriented within the nanocrystalline shell(s). In an embodiment, the nanocrystalline core and the nanocrystalline shell(s) form a quantum dot. In another embodiment, one or more additional semiconductor layers may be surround the quantum dot. An insulator layer may be formed so that it encapsulates, e.g., coats, the final semiconductor layer. After forming the first insulator layer, the coated quantum dot may be coated with subsequent insulator layers. In between the formation of each insulator layer, the coated quantum dot may optionally be treated with an acid or base as described above.

In any case, the insulator layer may individually encapsulate each nanocrystalline shell/nanocrystalline core pairing. In an embodiment, the semiconductor structure further includes a nanocrystalline outer shell at least partially surrounding the nanocrystalline shell, between the nanocrystalline shell and the insulator layer. The nanocrystalline outer shell is composed of a third semiconductor material different from the semiconductor material of the shell and, possibly, different from the semiconductor material of the core.

With reference to the above described coated nanocrystalline core and nanocrystalline shell pairings, in an embodiment, the insulator layer is bonded directly to the nanocrystalline shell. In one such embodiment, the insulator layer passivates an outermost surface of the nanocrystalline shell. In another embodiment, the insulator layer provides a barrier for the nanocrystalline shell and nanocrystalline core impermeable to an environment outside of the insulator layer.

With reference again to the above described coated nanocrystalline core and nanocrystalline shell pairings, in an embodiment, the insulator layer comprises a layer of material such as, but not limited to, silica (SiOx), titanium oxide (TiOx), zirconium oxide (ZrOx), alumina (AlOx), or hafnia (HfOx). In one such embodiment, the layer is silica having a thickness approximately in the range of 3-500 nanometers. In an embodiment, the insulator layer is an amorphous layer.

With reference again to the above described coated nanocrystalline core and nanocrystalline shell pairings, in an embodiment, an outer surface of the insulator layer is ligand-free. However, in an alternative embodiment, an outer surface of the insulator layer is ligand-functionalized. In one such embodiment, the outer surface of the insulator layer is ligand-functionalized with a ligand such as, but not limited to, a silane having one or more hydrolyzable groups or a functional or non-functional bipodal silane. In another such embodiment, the outer surface of the insulator layer is ligand functionalized with a ligand such as, but not limited to, mono-, di-, or tri- alkoxysilanes with three, two or one inert or organofunctional substituents of the general formula (R10)3SiR2; (R10)2SiR2R3; (RIO) SiR2R3R4, where R1 is methyl, ethyl, propyl, isopropyl, or butyl, R2,R3 and R4 are identical or different and are H substituents, alkyls, alkenes, alkynes, aryls, halogeno-derivates, alcohols, (mono, di, tri, poly) ethyleneglycols, (secondary, tertiary, quaternary) amines, diamines, polyamines, azides, isocyanates, acrylates, metacrylates, epoxies, ethers, aldehydes, carboxylates, esters, anhydrides, phosphates, phosphines, mercaptos, thiols, sulfonates, and are linear or cyclic, a silane with the general structure (R10)3Si-(CH2)n-R-(CH2)n-Si(R0)3 where R and R1 is H or an organic substituent selected from the group consisting of alkyls, alkenes, alkynes, aryls, halogeno-derivates, alcohols, (mono, di, tri, poly) ethyleneglycols, (secondary, tertiary, quaternary) amines, diamines, polyamines, azides, isocyanates, acrylates, metacrylates, epoxies, ethers, aldehydes, carboxylates, esters, anhydrides, phosphates, phosphines, mercaptos, thiols, sulfonates, and are linear or cyclic, a chlorosilane, or an azasilane.

In another such embodiment, the outer surface of the insulator layer is ligand functionalized with a ligand such as, but not limited to, organic or inorganic compounds with functionality for bonding to a silica surface by chemical or non-chemical interactions such as but not limited to covalent, ionic, H-bonding, or Van der Waals forces. In yet another such embodiment, the outer surface of the insulator layer is ligand-functionalized with a ligand such as, but not limited to, the methoxy and ethoxy silanes (MeO)3SiAllyl, (MeO)3SiVinyl, (MeO)2SiMeVinyl, (EtO)3SiVinyl, EtOSi(Vinyl)3, mono-methoxy silanes, chloro-silanes, or l,2-bis-(triethoxysilyl)ethane.

In any case, in an embodiment, the outer surface of the insulator layer is ligand-functionalized to impart solubility, dispersability, heat stability, photo-stability, or a combination thereof, to the semiconductor structure. For example, in one embodiment, the outer surface of the insulator layer includes OH groups suitable for reaction with an intermediate linker to link small molecules, oligomers, polymers or macromolecules to the outer surface of the insulator layer, the intermediate linker one such as, but not limited to, an epoxide, a carbonyldiimidazole, a cyanuric chloride, or an isocyanate.

With reference again to the above described coated nanocrystalline core and nanocrystalline shell pairings, in an embodiment, the nanocrystalline core has a diameter approximately in the range of 2- 6 nanometers. The nanocrystalline shell has a long axis and a short axis, the long axis having a length approximately in the range of 6 - 4 0 nanometers, and the short axis having a length approximately in the range of 1-10 nanometers greater than the diameter of the nanocrystalline core. The insulator layer has a thickness approximately in the range of 1- 50 nanometers along an axis co-axial with the long axis and has a thickness approximately in the range of 3- 50 nanometers along an axis co-axial with the short axis. In other embodiments, the thickness of the insulator layer may be greater than 50 nanometers, for example, up to 500 nanometers.

A lighting apparatus may include a light emitting diode and a plurality of semiconductor structures that, for example, act to down convert light absorbed from the light emitting diode. For example, in one embodiment, each semiconductor structure includes a quantum dot having a nanocrystalline core composed of a first semiconductor material and a nanocrystalline shell composed of a second, different, semiconductor material at least partially surrounding the nanocrystalline core. Each quantum dot has a photoluminescence quantum yield (PLQY) of at least 90%. Each quantum dot may optionally have additional semiconductor layers.

As described briefly above, a quantum dot is formed, including for example, at least one nanocrystalline shell and anisotropic nanocrystalline core. Then an insulator 15 layer may be formed to encapsulate the quantum dot structure. For example, in an embodiment, a layer of silica is formed using a reverse micelle sol-gel reaction. In one such embodiment, using the reverse micelle sol-gel reaction includes dissolving the nanocrystalline shell/ nanocrystalline core pairing in a first non-polar solvent to form a first solution. Subsequently, the first solution is added along with a species such as, but not limited to, 3-aminopropyltrimethoxysilane (APTMS), 3-mercapto-trimethoxysilane, or a silane comprising a phosphonic acid or carboxylic acid functional group, to a second solution having a surfactant dissolved in a second non-polar solvent. Subsequently, ammonium hydroxide and tetraorthosilicate (TEOS) are added to the second solution.

Thus, semiconductor nanocrystals coated with silica according to the present invention may be made by a sol-gel reaction such as a reverse micelle method. As an example, Figure 4 illustrates operations in a reverse micelle approach to coating a semiconductor structure, in accordance with an embodiment of the present invention. Referring to part A of Figure 4, a quantum dot heterostructure (QDH) 402 (e.g., a nanocrystalline core/shell pairing) has attached thereto one or more of trioctylphosphine oxide (TOPO) ligands 404, trioctylphosphine (TOPO) ligands 406, and Oleic Acid 405. Referring to part B, the TOPO ligands 404, TOP ligands 406, and Oleic Acid 405, are exchanged with a plurality of Si(OCH3)3(CH2)3NH2 ligands 408. The structure of part B is then reacted with TEOS (Si(OEt)4) and ammonium hydroxide (NH40H) to form a silica coating 410 surrounding the QDH 402, as depicted in part C of Figure 4.

With reference again to the above-described method of forming coated nanocrystalline core and nanocrystalline shell pairings, i.e., coated semiconductor quantum dots, in an embodiment, the first and second non-polar solvents are cyclohexane. In an embodiment, forming the coating layer includes forming a layer of silica and further includes using a combination of dioctyl sodium sulfosuccinate (AOT) and tetraorthosilicate (TEOS). In another embodiment, however, forming the layer includes forming a layer of silica and further includes using a combination of polyoxyethylene (5) nonylphenylether and tetraorthosilicate (TEOS). In another embodiment, however, forming the layer includes forming a layer of silica and further includes using cationic surfactants such as CTAB (cetyltrimethylammonium bromide), anionic surfactants, non-ionic surfactants, or pluronic surfactants such as Pluronic F127 (an ethylene oxide/ propylene oxide block co-polymer) as well as mixtures of surfactants.

Upon initiation of growth of a silica coating, the final size of that coating may be directly related to the amount of TEOS in the reaction solution. Silica coatings according to embodiments of the present invention may be conformal to the core/shell QDH or non-conformal. A silica coating may be between about 3nm and 500 nm thick. The silica coating thickness along the c-axis may be as small as about1 nm or as large as about 500 nm. The silica coating thickness along the a-axis may be between about 3 nm and 500 nm. Once silica coating is complete, the product is washed with solvent to 25 remove any remaining ligands. The silica-coated quantum dots can then be incorporated into a polymer matrix or undergo further surface functionalization. However, silica layers according to embodiments of the present invention may also be functionalized with ligands to impart solubility, dispersability, heat stability and photostability in the matrix.

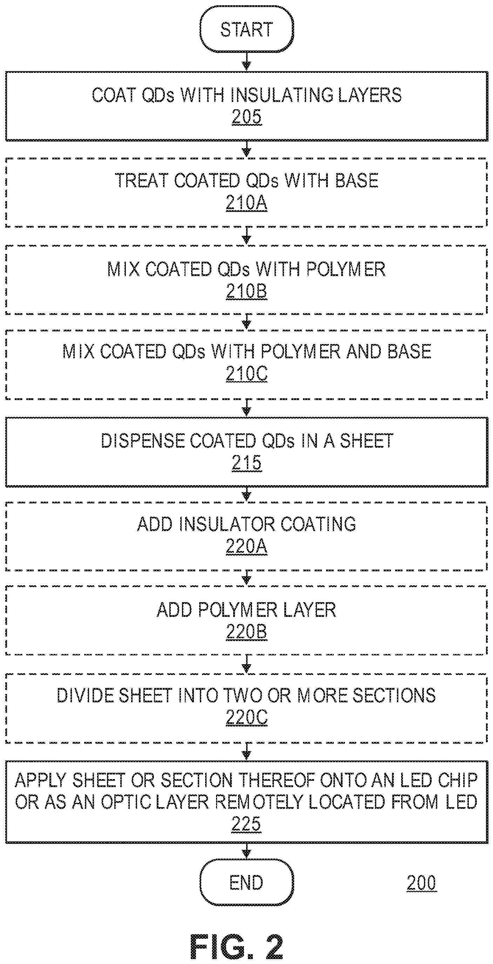

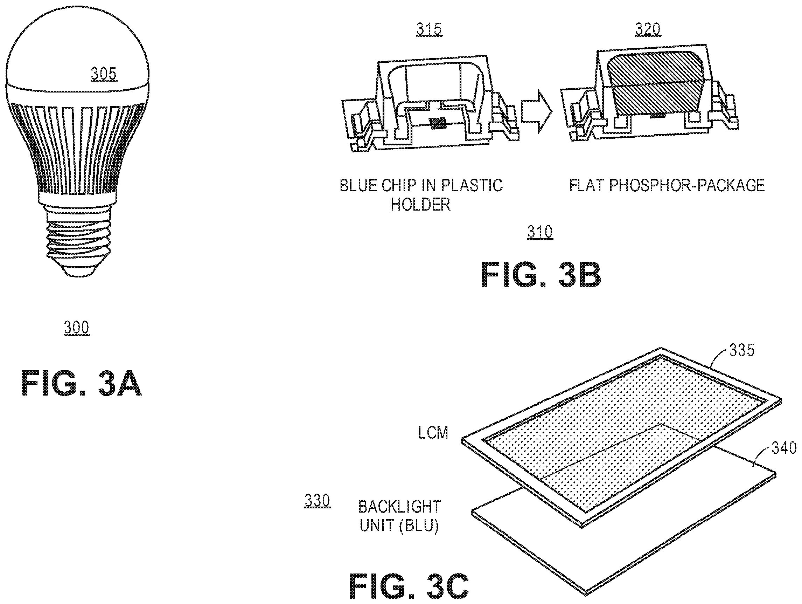

With reference to Figs. 2 and 3A-3C, some embodiments of the invention 200 may produce a quantum dots-based sheet for use in LED lighting and display devices or components, such as an LED light bulb 300, LED chip package 310, or display device 330, respectively depicted in Figs. 3A-3C. In particular, quantum dots are encapsulated with one or more layers of an insulating coating at 205 and then dispensed in a thin layer onto or into a sheet or film at 215.

The sheet may then, optionally, be divided into sections at 220C. In one embodiment, the coated quantum dots sheet is applied to the LED chip 315 for use as a color converter, or installed as a separate optic layer or component 305 in a luminaire for lighting (e.g., applied to an outer surface of light bulb 300), or in a back-light unit 340 of an electronic display device, or in a Liquid Crystal Monitor 335, to down convert blue light from a remotely placed or located (with respect to the coated quantum dots sheet) LED device.

Such embodiments may provide several advantages over the use of non-insulating-coated quantum dots in a sheet. First, such embodiments ensure that there are little to no interactions between quantum dots, because each quantum dot is individually coated with an insulating layer. The added insulating layer is thick enough to ensure that even if the outer surfaces of the insulator coated quantum dots are touching, they still have adequate spacing between them due to the coating. See, for example, the Transmission Electron Microscope (TEM) image in Fig.1, wherein the individual quantum dots 100 are coated with enough insulating material 110 to ensure adequate monodispersity. The insulating layer also ensures that there is a layer of protection around each quantum dot, allowing it to maintain performance during device operating conditions, even without additional oxygen and moisture barriers.

The sheet of coated quantum dots can take many forms. In one embodiment, insulator-coated quantum dots are cast at 215 onto a transparent substrate to form a thin layer of coated quantum dots. The transparent substrate can be, for example, a plastic substrate, a quartz substrate or a glass substrate. Representative examples of plastic substrates are polycarbonate, polyester, polyethersulfone, polyimide, polyethylene terephthalate, polyethylene, and polyethylene naphthalate. In some embodiments, the substrate may also be an existing component of a luminaire for lighting, or of a back-light unit for electronic display devices.

In one embodiment, after dispensing of the coated quantum dots in a sheet at 215, a non-quantum dot containing polymer layer is optionally cast at 220B over the coated quantum dots sheet. The polymer layer can be, for example, silicone, epoxy, acrylic, or polyurethane-based, resins. In one embodiment, silicone resins are generally used for LED encapsulants because of their thermal stability, transparency and resistance to oxygen and UV light.

In embodiments wherein the coated quantum dots sheet is installed as a remote component in an LED lighting or display device (that is, wherein the coated quantum dots sheet is not applied directly adjacent to the LED device), the concentration of the coated quantum dots may vary across the component to reduce edge or hot spot effects (by, for example, increasing the concentration of coated quantum dots where the remote component is closest to blue LEDs).

In another embodiment, the insulator-coated quantum dots are directly incorporated into a transparent medium at 215 to make a sheet. The transparent medium can be for example plastic, quartz, glass, or some other existing material in a luminaire or electronic display device. After preparing the sheet containing the coated quantum dots, the sheet may be either divided into smaller sections at 220C and applied at 225 directly to an LED device for use as a color converter, or used as a separate optic component to down convert the blue light from a remotely located LED.

In another embodiment, prior to casting (that is, prior to dispensing the coated quantum dots in a sheet at 215), the insulator-coated quantum dots are optionally treated at 210A with a base, such as, but not limited to, NaOH, KOH, LiOH, RbOH, CsOH, MgOH, Ca(OH)2, Sr(OH)2, Ba(OH)2, (Me)4NOH, (Et)4NOH, or (Bu)4NOH.

In another embodiment, insulator-coated quantum dots are mixed at 21OB with a polymer. In various embodiments, polymers include silicones, epoxies, acrylics and polyurethane-based resins. After mixing, the quantum dots/ polymer mixture is cast or dispensed on to a clear substrate, for example a plastic substrate, at 215. Finally, the sheet may be divided into smaller sections at 220C and is used as a separate optic layer to down convert blue light from a remotely placed LED.

In yet another embodiment, insulator-coated quantum dots, a polymer, selected from silicon, epoxy, acrylic and polyurethane-based resin, and base(s) are mixed together at 210C. The base may comprise, but is not limited to, NaOH, KOH, LiOH, RbOH, CsOH, MgOH, Ca(OH)2, Sr(OH)2, Ba(OH)2, (Me)4NOH, (Et)4NOH, or (Bu)4NOH. After mixing, the insulator-coated quantum dots/ polymer/base(s) mixture is cast at 215 onto a transparent substrate, such as another polymer, quartz, or glass. The substrate may also be an existing or new layer or component of a luminaire for lighting, or of a back-light unit for displays. Finally, the substrate may be divided at 220C into smaller sections and is used as a separate optic layer to down convert the blue light from a remotely placed LED.

In another embodiment, after the insulator-coated quantum dots are cast onto a transparent substrate to form a thin layer at 215, optionally, an additional insulator coating is deposited at 220A to cover the quantum dot layer, for example, by Atomic Layer Deposition (ALD) processes. Examples of this additional insulator coating include layers of inorganic materials such as AI2O3, SiOx, and SiNx as well as transition metals including copper, cobalt, and iron deposited by ALD. The insulator coating can also include multiple alternating layers of inorganic materials and organic materials such as parylene. In one embodiment, a polymer layer may be optionally cast at 220B over the insulator coating. The polymer layer can be silicon, epoxy, acrylic and polyurethane-based resin. After preparing the sheet, the sheet is inserted and used as a separate optic layer or component to down convert blue light from a remotely placed LED. In one embodiment, before the insulator-coated quantum dots are cast onto the transparent substrate to form a thin layer at 215 and the additional insulator coating is deposited to cover the quantum dot layer at 220A, the insulator-coated quantum dots may be treated at 210A with base, such as, but not limited to, NaOH, KOH, LiOH, RbOH, CsOH, MgOH, Ca(OH)2, Sr(OH)2, Ba(OH)2, (Me)4NOH, (Et)4NOH, or (Bu)4NOH.

In another aspect, quantum dot composite compositions are described. For example, the quantum dots (including coated quantum dots) described above may be embedded in a matrix material to make a composite using a plastic or other material as the matrix. In an embodiment, composite compositions including matrix materials and silica coated core/shell quantum dots having photoluminescence quantum yields between 90 and 100% are formed. Such quantum dots may be incorporated into a matrix material suitable for down converting in LED applications.

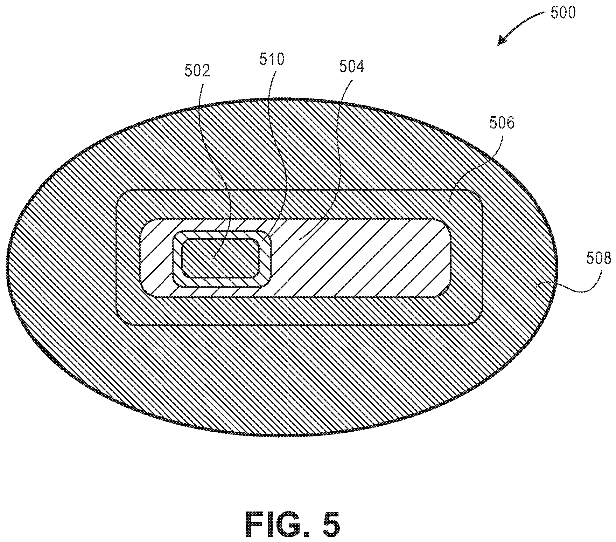

In another example, and as illustrated in Fig. 5 below, a semiconductor structure has a nanocrystalline core and nanocrystalline shell pairing with one compositional transition layer, in accordance with an embodiment of the present invention.

Referring to Fig. 5, a semiconductor structure 500 includes a nanocrystalline core 502 composed of a first semiconductor material. A nanocrystalline shell 504 composed of a second, different, semiconductor material at least partially surrounds the nanocrystalline core 502. A compositional transition layer 510 is disposed between, and in contact with, the nanocrystalline core 502 and nanocrystalline shell 504. The compositional transition layer 510 has a composition intermediate to the first and second semiconductor materials.

In an embodiment, the compositional transition layer 510 is an alloyed layer composed of a mixture of the first and second semiconductor materials. In another embodiment, the compositional transition layer 510 is a graded layer composed of a compositional gradient of the first semiconductor material proximate to the nanocrystalline core 502 through to the second semiconductor material proximate to the nanocrystalline shell 504. In either case, in a specific embodiment, the compositional transition layer 510 has a thickness approximately in the range of 1.5 - 2 monolayers. Exemplary embodiments include a structure 500 where the first semiconductor material is cadmium selenide (CdSe), the second semiconductor material is cadmium sulfide (CdS), and the compositional transition layer 510 is composed of CdSexSy, where 0 < x <1 and 0 < y < 1, or where the first semiconductor material is cadmium selenide (CdSe), the second semiconductor material is zinc selenide (ZnSe), and the compositional transition layer 510 is composed of CdxZnySe, where 0 < x <1 and 0 < y < 1.

In an embodiment, the nanocrystalline shell 504 completely surrounds the nanocrystalline core 502, as depicted in Figure 5. In an alternative embodiment, however, the nanocrystalline shell 504 only partially surrounds the nanocrystalline core 502, exposing a portion of the nanocrystalline core 502. Furthermore, in either case, the nanocrystalline core 502 may be disposed in an asymmetric orientation with respect to the nanocrystalline shell 504. In one or more embodiments, semiconductor structures such as 500 are fabricated to further include a nanocrystalline outer shell 506 at least partially surrounding the nanocrystalline shell 504. The nanocrystalline outer shell 506 may be composed of a third semiconductor material different from the first and second semiconductor materials, i.e., different from the materials of the core 502 and shell 504. The nanocrystalline outer shell 506 may completely surround the nanocrystalline shell 504 or may only partially surround the nanocrystalline shell 504, exposing a portion of the nanocrystalline shell 504. Lastly, an insulator layer 508 encapsulates the shell 506.

In another embodiment, a network of quantum dots may be formed by fusing together the insulator coatings of a plurality of insulator-coated quantum dots. For example, in accordance with an embodiment of the present invention, insulator coatings of discrete passivated quantum dots are fused together to form a substantially rigid network of quantum dots where each quantum dot is isolated from other quantum dots in the network by the fused insulator coating. In one such embodiment, fusing together the insulator coatings of discretely passivated quantum dots into a fused network provides improved optical and reliability performance of the resulting structure as compared with the starting discretely passivated quantum dots. In one such embodiment, a chemical base is used to improve the optical performance of silica coated materials by enabling the fusing of the insulator coatings surrounding a plurality of quantum dots. In a specific embodiment, the insulator coating is a silica coating and a base such as potassium hydroxide (KOH) is used to fuse together the silica coatings of a plurality of individually and discretely coated quantum dots. The result is a substantially rigid silica-based network of quantum dots. The amount of base material is scaled with the amount of silica in the reaction. In general, the approaches described herein have important applications for improving the optical and reliability performance of quantum dots or even other phosphor materials having an insulator coating and which are embedded in a matrix. In one such embodiment, the quantum dots or other phosphor materials are first individually coated with one or more insulator layers and then the coated materials are fused to form an insulator network that can be embedded in a matrix. In other embodiments, the insulator network is formed directly on the quantum dots or other phosphor materials.

In an embodiment, then, with respect to using colloidal semiconductor nanocrystals, also known as quantum dots, as downshifting fluorescent materials for LED lighting and/ or display technologies, quantum dots are individually coated with a silica insulator layer. The presence of the silica coating improves the performance of the quantum dots when they are subsequently embedded in a polymer film and subjected to various stress tests. Applications include LED lighting applications and/or display configurations. The use of base (such as KOH, NaOH or other similar materials) provides a fused network of the silica coated quantum dots to improve the optical performance of silica quantum dot materials. As described below, in particular embodiments, the scaling of the amount of KOH or other base with silica content is balanced to achieve optimal performance of the coated/fused quantum dots.

In an embodiment, a method of fabricating a semiconductor structure involves forming a mixture including a plurality of discrete semiconductor quantum dots. Each of the plurality of discrete semiconductor quantum dots is discretely coated by an insulator layer. The method also involves adding a base to the mixture to fuse the insulator layers of each of the plurality of discrete quantum dots, providing an insulator network. Each of the plurality of discrete semiconductor quantum dots is spaced apart from one another by the insulator network. The base may be comprised of, but is not limited to, LiOH, RbOH, CsOH, MgOH, Ca(OH)2, Sr(OH)2, Ba(OH)2, (Me)4NOH, (Et)4NOH, or (Bu)4NOH.

In another embodiment, a method of fabricating a semiconductor structure involves forming a mixture including a plurality of discrete semiconductor quantum dots. Each of the plurality of discrete semiconductor quantum dots is discretely coated by an insulator material. The method also involves adding a base to the mixture to fuse the insulator coating of each of the plurality of discrete semiconductor quantum dots, providing an insulator network. Each of the plurality of discrete semiconductor quantum dots is spaced apart from one another by the insulator network. The base may be comprised of, but is not limited to, LiOH, RbOH, CsOH, MgOH, (Me)4NOH, (Et)4NOH, or (Bu)4NOH, and adding the base to the mixture involves adding one mole of the base for every two moles of the insulator material. The method also involves adding free silica to the mixture.

In another embodiment, a method of fabricating a semiconductor structure involves forming a mixture including a plurality of discrete semiconductor nanocrystals. Each of the plurality of discrete semiconductor nanocrystals is discretely coated by an insulator shell material. The method also involves adding a base to the mixture to fuse the insulator shells of each of the plurality of discrete nanocrystals, providing an insulator network. Each of the plurality of discrete semiconductor nanocrystals is spaced apart from one another by the insulator network. The base one such as, but not limited to, Ca(OH)2, Sr(OH)2 or Ba(OH)2, and adding the base to the mixture involves adding one mole of the base for every four moles of the insulator shell material. The method also involves adding free silica to the mixture.

In accordance with one or more embodiments herein, an alternative to altering seed size for tuning the emission of a seeded rod emitter architecture is provided. More particularly, instead of changing seed size, the seed composition is changed by alloying either the entire seed (in one embodiment) or some portion of the seed (in another embodiment) with a higher bandgap material. In either case, the general approach can be referred to as an alloying of the seed or nanocrystalline core portion of a heterostructure quantum dot. By alloying the seed or nanocrystalline core, the bandgap can be changed without changing the size of the seed or core. As such, the emission of the seed or core can be changed without changing the size of the seed or core. In one such embodiment, the size of the seed is fixed at the optimum size of a red-emitting seed, or roughly 4 nanometers. The fixed sized means that the size of the rod and the subsequent synthetic operations may not need to be substantially re-optimized or altered as the emission target of the quantum dots is changed.

Accordingly, in one or more embodiments described herein, optimum physical dimensions of a seeded rod are maintained as constant while tuning the emission peak of the heterostructure quantum dot. This can be performed without changing the dimensions of the seed (and therefore the rod) for each emission color. In a particular embodiment, a quantum dot includes an alloyed Group TI-VI nanocrystalline core. The quantum dot also includes a Group II-VI nanocrystalline shell composed of a semiconductor material composition different from the alloyed Group II-VI nanocrystalline core. The Group II-VI nanocrystalline shell is bonded to and completely surrounds the alloyed Group II-VI nanocrystalline core. In one such embodiment, the alloyed Group II-VI nanocrystalline core is composed of CdSenSl-n (0 < n < 1), and the Group II-VI nanocrystalline shell is composed of CdS. In a specific embodiment, the alloyed Group II-VI nanocrystalline core has a shortest diameter of greater than approximately 2 nanometers, and the quantum dot has an exciton peak less than 555 nanometers. In a particular embodiment, the alloyed Group II-VI nanocrystalline core has a shortest diameter of approximately 4 nanometers, and the quantum dot has an exciton peak less than 555 nanometers, as is described in greater detail below.

Perhaps more generally, in an embodiment, a quantum dot includes a semiconductor nanocrystalline core of arbitrary composition. The quantum dot also includes any number of semiconductor nanocrystalline shell(s). The semiconductor nanocrystalline shell(s) is/are bonded to and completely surrounds the semiconductor nanocrystalline core. In one such embodiment, the semiconductor nanocrystalline core is composed of a first Group II-VI material, and the binary semiconductor nanocrystalline shell is composed of a second, different, Group II-VI material. In one such embodiment, the first Group II-VI material is CdSenSl-n (0 < n < 1), and the second Group II-VI material is CdS.

One or more embodiments described herein involve fabrication of a semiconductor hetero-structure. The semiconductor hetero-structure has a nanocrystalline core composed of a group semiconductor material. A nano-crystalline shell composed of a second, different, semiconductor material at least partially surrounds the nano-crystalline core. For example, the nano-crystalline shell may be composed of a different group I-III-VI semiconductor material or of a group II-VI semiconductor material.

In one such embodiment, the above described nano-crystalline core/ nano-crystalline shell pairing has a photoluminescence quantum yield (PLQY) of greater than approximately 60%. In another, or same, such embodiment, the nano-crystalline core/ nano-crystalline shell pairing provides a Type I hetero-structure. One or more embodiments described herein are directed to hetero-structure systems having distinct group 1-III-VI material cores. In an exemplary embodiment, a sphere or rod-shaped core/shell quantum dot is fabricated to have a sharp compositional interface between the core and shell or a graded/alloyed interface between core and shell.

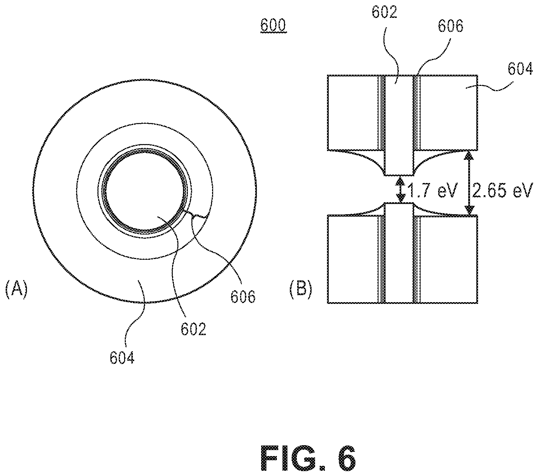

Fig. 6 illustrates an axial cross-sectional view (A) of a spherical nano-particle 600, in accordance with an embodiment of the present invention. Referring to Figure 6, an alloy region 606 is included between the core 602 and shell 604 of 600. As shown in part (B) of Figure 6, in one embodiment, the nano-particle 600 demonstrates type I heterostructure behavior, with excitons preferentially recombining in the core 602 of the nanocrystal 600 due to the smaller, nested bandgap of the seed. Optionally, additional layers of material may be added, including additional epitaxial layers or amorphous inorganic and organic layers. Other suitable embodiments are described below.

In an embodiment, systems described herein include a nano-crystalline core emitter having a direct, bulk band gap approximately in the range of 1- 2.5 eV. Exemplary cores include a group I-III-VI semiconductor material based on silver gallium sulfide having a stoichiometry of approximately AgGaS2. In one such embodiment, the nano-crystalline core has a peak emission approximately in the range of 475-575 nanometers.

In one or more embodiments, the nano-crystalline core and nano-crystalline shell pairings described herein have a lattice mismatch of equal to or less than approximately 10%. In some embodiments, less than approximately 6% mismatch is preferable, but up to approximately 10% can be workable. In particular embodiments, the mismatch is less than approximately 4% mismatch, as seen in successful Cd-based systems.

One or more embodiments described herein is directed to a hetero-structure core/shell pairing that is cadmium-free. For example, with reference to the above described nano-crystalline core and nano-crystalline shell pairings, in an embodiment, the first (core) material is a group I-III-VI semiconductor material. In one such embodiment, the second (shell) semiconductor material is a second group I-III-VI material. For example, a suitable I-III-VI/ I-III-VI core/shell pairing can include, but is not limited to, copper indium sulfide (CIS)/silver gallium sulfide (AgGaS2), copper indium selenide (CISe)/ AgGaS2, copper gallium selenide (CuGaSe2)/copper gallium sulfide (CuGaS2), or CuGaSe2/ AgGaS2. In another such embodiment, the second (shell) semiconductor material is a group II-VI material. For example, a suitable I-IIIVI/ II-VI core/ shell pairing can include, but is not limited to, copper indium sulfide (CIS)/ zinc selenide (ZnSe), CIS/ zinc sulfide (ZnS), copper indium selenide (CISe)/ ZnSe, CISe/ ZnS, copper gallium selenide (CuGaSe2)/ ZnSe, CuGaSe2/ZnS, silver gallium sulfide (AgGaS2)/ ZnS, AgGaS2/ ZnSe, or silver gallium selenide (AgGaSe2)/ ZnS, AgGaSe2/ ZnSe.

In an embodiment, the semiconductor hetero-structure further includes a nano-crystalline outer shell composed of a third semiconductor material different from the core and shell semiconductor materials. The third semiconductor material at least partially surrounding the nano-crystalline shell and, in one embodiment, the nano-crystalline outer shell completely surrounds the nano-crystalline shell. In a particular embodiment, the second (shell) semiconductor material one such as, but not limited to, zinc selenide (ZnSe), silver gallium sulfide (AgGaS2) or copper gallium sulfide (CuGaS2), and the third (outer shell) semiconductor material is zinc sulfide (ZnS).

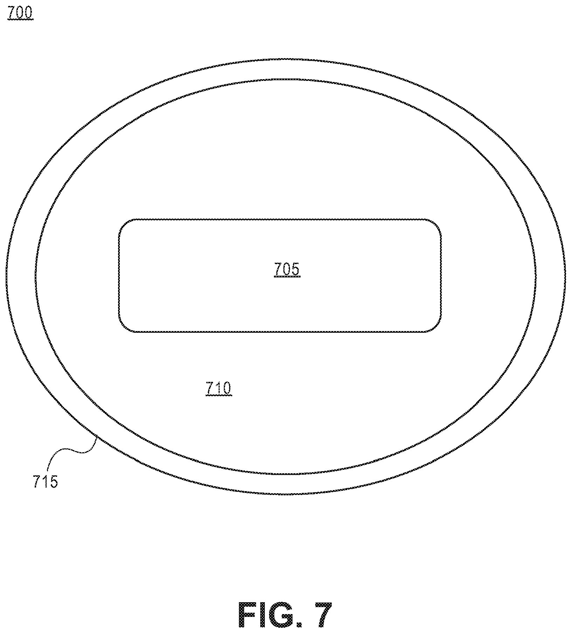

Fig. 7 illustrates a structure 700 comprising a quantum dot heterostructure 705 that is made and coated with an insulating layer 710, for example, a metal oxide layer, in solution, using methods such as the Stoeber or Igepal method. The coated quantum dots are then dried and coated with an additional insulating layer 715 of metal oxide. It is to be appreciated that while the shape of the core of the quantum dot depicted in Fig. 7 is that of a rod, the methods described herein are not limited by the shape of the quantum dot and could be applied to coated quantum dots of multiple shapes, including spheres, rods, tetrapods, teardrops, sheets, etc. Furthermore, embodiments of the invention are not limited by the composition of the quantum dot and can be applied to quantum dots made from a single material or multiple materials in either a core/shell/ optional shell/ optional shell configuration or an alloyed composition. The semiconductor materials may be selected from the Group II-VI compounds, Group III-V compounds, group IV-IV compounds, group I-III-VI compounds, or any alloy thereof. More specifically the semiconductor materials may be chosen from ZnO, ZnS, ZnSe, ZnTe, CdO, CdS, CdSe, CdTe, HgS, HgSe, HgTe, HgO, AIN, A1P, AlAs, AlSb, GaN, GaP, GaAs, GaSb, GaSe, InN, InP, InAs, InSb, TIN, TIP, TIAs, TISb, PbS, PbSe, PbTe, MgO, MgS, MgSe, alloys thereof, and mixtures thereof.

## Claims

1. A method, comprising:
coating a plurality of quantum dots with one or more insulating layers;
dispensing the coated quantum dots in a sheet; and
installing the coated quantum dots sheet as a remote component in an light emitting diode (LED) lighting or electronic display device,
wherein after coating the plurality of quantum dots with one or more insulating layers and before dispensing the coated quantum dots in a sheet, treating the coated quantum dots with a base, or mixing the coated quantum dots with a polymer, or
mixing the coated quantum dots with a polymer and a base, and
wherein dispensing the coated quantum dots in a sheet comprises dispensing a varying concentration of coated quantum dots across the sheet.

2. The method of claim 1, wherein installing the coated quantum dots sheet in an light emitting diode (LED) lighting or display device comprises inserting the coated quantum dots sheet as a downconversion layer in a luminaire for lighting, or in a back-light unit of an electronic display device, to down convert blue light from a remotely placed LED device.

3. The method of claim 1, wherein the sheet comprises a transparent substrate, and wherein the transparent substrate is selected from a group of materials consisting of a plastic substrate, a quartz substrate, and a glass substrate.

4. The method of claim 3, wherein the plastic substrate is selected from a group of plastic substrates consisting of:
polycarbonate, polyester, polyethersulfone, polyimide,
polyethylene terephthalate, polyethylene, and polyethylene naphthalate.

5. The method of claim 1, further comprising applying a non-quantum dot containing polymer layer over the coated quantum dots sheet.

6. The method of claim 5, wherein the polymer layer is selected from a group of resins consisting of: silicone-, epoxy-, acrylic-, and polyurethane-based resins.

7. The method of claim 1, wherein dispensing the coated quantum dots in a sheet comprises dispensing the coated quantum dots in a layer onto the sheet.

8. The method of claim 7, wherein after dispensing the coated quantum dots in a layer onto the sheet, depositing an insulator coating that covers the coated quantum dots layer on the sheet.

9. The method of claim 8, wherein after depositing the insulator coating that covers the coated quantum dots layer on the sheet, depositing a polymer layer over the insulator coating.

10. The method of claim 1, wherein dispensing the coated quantum dots in a sheet comprises directly incorporating the coated quantum dots into the sheet.

## Patentansprüche

1. Ein Verfahren aufweisend:
Beschichten einer Vielzahl von Quantenpunkten mit einer oder mehreren isolierenden Schichten;
Verteilen der beschichteten Quantenpunkte in einer Folie; und Installieren der Folie mit beschichteten Quantenpunkten als eine entfernte Komponente in einer Leuchtdioden- (LED) Beleuchtungs- oder elektronischen Anzeigevorrichtung,
wobei nach dem Beschichten der Vielzahl von Quantenpunkten mit einer oder mehreren isolierenden Schichten und vor dem Verteilen der beschichteten Quantenpunkte in einer Folie die beschichteten Quantenpunkte mit einer Base behandelt werden oder die beschichteten Quantenpunkte mit einem Polymer gemischt werden oder die beschichteten Quantenpunkte mit einem Polymer und einer Base gemischt werden, und
wobei das Verteilen der beschichteten Quantenpunkte in einer Folie Verteilen einer variierenden Konzentration von beschichteten Quantenpunkten über die Folie aufweist.

2. Das Verfahren von Anspruch 1, wobei das Installieren der Folie mit beschichteten Quantenpunkten in einer Leuchtdioden-(LED) Beleuchtungs- oder Anzeigevorrichtung Einsetzen der beschichteten Quantenpunktfolie als Abwärtsumwandlungsschicht in eine Leuchte für die Beleuchtung oder in eine Rücklichteinheit einer elektronischen Anzeigevorrichtung aufweist, um blaues Licht von einer entfernt angeordneten LED-Vorrichtung abwärts umzuwandeln.

3. Das Verfahren von Anspruch 1, wobei die Folie ein transparentes Substrat aufweist und wobei das transparente Substrat aus einer Gruppe von Materialien ausgewählt ist, die aus einem Kunststoffsubstrat, einem Quarzsubstrat und einem Glassubstrat besteht.

4. Das Verfahren von Anspruch 3, wobei das Kunststoffsubstrat aus einer Gruppe von Kunststoffsubstraten ausgewählt ist, die aus Polycarbonat, Polyester, Polyethersulfon, Polyimid, Polyethylenterephthalat, Polyethylen und Polyethylennaphthalat besteht.

5. Das Verfahren von Anspruch 1, ferner aufweisend Aufbringen einer nicht quantenpunkthaltigen Polymerschicht auf die Folie mit beschichteten Quantenpunkten.

6. Das Verfahren von Anspruch 5, wobei die Polymerschicht aus einer Gruppe von Harzen ausgewählt ist, die aus Silikon-, Epoxy-, Acryl- und Polyurethanharzen besteht.

7. Das Verfahren von Anspruch 1, wobei das Verteilen der beschichteten Quantenpunkte in einer Folie Verteilen der beschichteten Quantenpunkte in einer Schicht auf die Folie aufweist.

8. Das Verfahren von Anspruch 7, wobei nach dem Verteilen der beschichteten Quantenpunkte in einer Schicht auf die Folie eine Isolatorbeschichtung aufgebracht wird, die die Schicht mit den beschichteten Quantenpunkten auf der Folie bedeckt.

9. Das Verfahren von Anspruch 8, wobei nach dem Aufbringen der Isolatorbeschichtung, die die Schicht mit den beschichteten Quantenpunkten auf der Folie bedeckt, eine Polymerschicht über der Isolatorbeschichtung aufgebracht wird.

10. Das Verfahren von Anspruch 1, wobei das Verteilen der beschichteten Quantenpunkte in einer Folie das direkte Einarbeiten der beschichteten Quantenpunkte in die Folie aufweist.

## Revendications

1. Une méthode comprenant
revêtir une pluralité de points quantiques avec une ou plusieurs couches isolantes;
distribuer les points quantiques revêtus en une feuille; et installer la feuille de points quantiques revêtus en tant que composant distant dans un dispositif d'affichage d'éclairage ou d'affichage électronique à diodes électroluminescentes (DEL),
dans lequel, après avoir revêtu la pluralité de points quantiques avec une ou plusieurs couches isolantes et avant de distribuer les points quantiques revêtus en une feuille, traiter les points quantiques revêtus avec une base, ou mélanger les points quantiques revêtus avec un polymère, ou mélanger les points quantiques revêtus avec un polymère et une base, et
dans lequel distribuer les points quantiques revêtus en une feuille comprend distribuer une concentration variable de points quantiques revêtus à travers la feuille.

2. La méthode de la revendication 1, dans lequel installer la feuille de points quantiques revêtus dans un dispositif d'éclairage ou d'affichage à diodes électroluminescentes (DEL) comprend insérer la feuille de points quantiques revêtus comme couche de conversion vers le bas dans un luminaire pour l'éclairage, ou dans une unité de rétro-éclairage d'un dispositif d'affichage électronique, pour convertir vers le bas la lumière bleue provenant d'un dispositif à DEL placé à distance.

3. La méthode de la revendication 1, dans lequel la feuille comprend un substrat transparent, et dans lequel le substrat transparent est choisi dans un groupe de matériaux constitué d'un substrat en plastique, d'un substrat en quartz, et d'un substrat en verre.

4. La méthode de la revendication 3, dans lequel le substrat plastique est choisi dans un groupe de substrats plastiques constitué de: polycarbonate, polyester, polyéthersulfone, polyimide, polyéthylène téréphtalate, polyéthylène, et polyéthylène naphtalate.

5. La méthode de la revendication 1, comprenant en outre appliquer une couche de polymère ne contenant pas de points quantiques au-dessus de la feuille de points quantiques revêtus.

6. La méthode de la revendication 5, dans lequel la couche de polymère est choisie dans un groupe de résines constitué de:
résines à base de silicone, d'époxy, d'acrylique et de polyuréthane.

7. La méthode de la revendication 1, dans lequel distribuer les points quantiques revêtus en une feuille comprend distribuer les points quantiques revêtus en une couche au-dessus de la feuille.

8. La méthode de la revendication 7, dans lequel après avoir distribué les points quantiques revêtus en une couche au-dessus de la feuille, déposer une couche isolante qui couvre la couche de points quantiques revêtus au-dessus de la feuille.

9. La méthode de la revendication 8, dans lequel après avoir déposé la couche isolante qui couvre la couche de points quantiques revêtus au-dessus de la feuille, déposer une couche de polymère au-dessus de la couche isolante.

10. La méthode de la revendication 1, dans lequel distribuer les points quantiques revêtus en une feuille comprend incorporer directement les points quantiques revêtus dans la feuille.
